# EUROPÄISCHE PATENTSCHRIFT

(11) **EP 0 392 603 B1**
(45) Veröffentlichungstag und Bekanntmachung des Hinweises auf die Patenterteilung: **16.07.1997**
(21) Anmeldenummer: 90200833.3
(22) Anmeldetag: 06.04.1990
(51) Int. Cl.: H04L 25/30, H03M 13/00

(54) **Übertragungssystem**
Transmission system
Système de transmission

(30) Priorität: 12.04.1989 DE 3911999
(43) Veröffentlichungstag der Anmeldung: 17.10.1990
(73) Patentinhaber: Philips Patentverwaltung GmbH, 22335 Hamburg (DE); Philips Electronics N.V., 5621 BA Eindhoven (NL)
(72) Erfinder: Koch, Wolfgang, Dr.-Ing., D-8501 Heroldsberg (DE)
(74) Vertreter: Peuckert, Hermann, Dipl.-Ing.

(56) Entgegenhaltungen:
- EP-A- 0 391 354
- IEEE INTERNATIONAL CONFERENCE ON COMMUNICATIONS ICC '86, 22.-25.06.1986, Toronto, CA, vol. 3, pages 1612-1616, IEEE, New York, US; T. SCHAUB / J.W. MODESTINO: 'An Erasure Declaring Viterbi Decoder and its Applications to Concatenated Systems'
- PROCEEDINGS OF THE IEEE, Bd. 61, Nr. 3, März 1973, New York, US, SS. 268-277; G.D. FORNEY: 'The Viterbi Algorithm'
- IEEE TRANSACTIONS ON INFORMATION THEORY Bd. 33, Nr. 6, November 1987, New York, US, SS. 866-876; T. HASHIMOTO: 'A List-Type Reduced-Constraint Generalization of the Viterbi-Algorithm'
- IEEE GLOBAL TELECOMMUNICATIONS CONFERENCE & EXHIBITION GLOBECOM '90, 02.-05.1990, San Diego, US, vol. 3, pp. 1679-1684, IEEE; New York, US; XP-218858; W. Koch/A. BAIER: 'Optimum and Sub-Optimum Detection of Coded Data Disturbed by Time-Varying Intersymbol Interference'
- P. HÖHER: 'Kohärenter Empfang trelliscodierter PSK-Signale auf frequenzselektiven Mobilfunkkanälen - Entzerrung, Decodierung und Kanalparameterschätzung'; Dissertation Universität Kaiserslautern, 12.07.1990; Fortschr.-Ber. VDI Reihe 10, Nr. 147, 1990, VDI-Verlag, Düsseldorf, DE
- J.G. PROAKIS: 'Digital Communications, 2nd Edition' 1989, MCGRAW-HILL, New York, US; SS. 610-627

## Beschreibung

Die Erfindung betrifft ein digitales Übertragungssystem mit einem Entzerrer zum Bilden von binären Schätzwerten aus einer Folge von Abtastwerten eines Signales, die Binärwerten Null oder Eins von ausgegebenen Binärzeichen zuordenbar sind und bei der jeder Abtastwert von dem ihm zuordenbaren Binärzeichen und von n unmittelbar diesem Binärzeichen vorangegangenen Binärzeichen abhängig ist, indem jedem Abtastwert 2ⁿ Zustände zugeordnet werden und jeweils für den Übergang von einem Zustand auf einen zeitlich nachfolgenden Zustand eine Maßzahl für die Wahrscheinlichkeit des Überganges zugeordnet wird und durch Aneinanderreihung von Zustandsübergängen Pfade gebildet werden, wobei aus allen Maßzahlen eines Pfades eine Gesamtmaßzahl gebildet wird und von allen auf einen Zustand führenden Pfaden nur jeweils der mit der minimalsten Gesamtmaßzahl betrachtet wird.

Die Erfindung betrifft weiter eine Sende-/Empfangseinrichtung mit einem Entzerrer für ein derartiges Übertragungssystem.

Bei digitalen Übertragungssystemen mit dispersiven Übertragungskanälen wird ein vom Sender gesendetes Signal, welches die zu übertragende Information in Form von Binärzeichen beinhaltet, durch Laufzeitunterschiede und Phasenverschiebungen beim Durchlaufen des Übertragungskanals verzerrt. Diese Verzerrungen bewirken, daß die im empfangenen Signal enthaltenen Binärzeichen durch vorangegangene Binärzeichen beeinflußt werden (Nachbarzeichenstörungen).

Dispersive Übertragungskanäle treten sowohl bei Funkübertragungssystemen als auch bei leitungsgebundener Übertragung auf. Laufzeitunterschiede und Phasenverschiebungen entstehen beispielsweise durch Reflektionen und bei Funkübertragungssystemen durch Mehrwegeausbreitung. Besonders bei Funkübertragungssystemen, bei denen Sende- bzw. Empfangsstationen ortsbeweglich sind, z.B. bei einem Autotelefonsystem, sind diese Verzerrungen zudem zeitvariant. Zusätzliche Verzerrungen entstehen durch Überlagerung der gesendeten Signale mit Rauschen oder sonstigen Störsignalen. Um den ursprünglichen Dateninhalt des Signales zurückzugewinnen, ist es erforderlich, das empfangene Signal zu entzerren.

Hierzu ist es beispielsweise aus dem in der europäischen Patentanmeldung EP-A-0 294 116 geschilderten Stand der Technik bekannt, unter Anwendung des sogenannten Viterbi-Verfahrens die ursprünglich gesendete Datenfolge zu rekonstruieren. In einem Empfänger werden durch Abtastung des empfangenen Signales Abtastwerte gebildet, die einem Viterbi-Entzerrer zugeführt werden. Jedem gesendeten Binärzeichen kann mindestens ein Abtastwert zugeordnet werden. Wegen der Abhängigkeit eines Abtastwertes von n zurückliegend gesendeten Binärzeichen führt der Viterbi-Entzerrer unter Einbeziehung von Wahrscheinlichkeitsberechnungen eine Schätzung durch, welchen Binärwert ein gesendetes Binärzeichen gehabt haben muß.

Weiterhin ist beispielsweise aus der europäischen Patentanmeldung EP-A-0 152 947 ein Viterbi-Decoder bekannt. Viterbi-Decoder werden in Übertragungssystemen als Kanaldecoder eingesetzt, bei denen auf der Sendeseite ein Kanalcoder und auf der Empfangsseite ein Kanaldecoder angeordnet ist. Bei solchen Übertragungssystemen wird eine zu übertragende Binärzeichenfolge von der Übertragung durch Codierung in eine codierte Datenfolge umgewandelt. Hierzu wird im Kanalcoder zur Codierung ein Faltungscode (convolutional code) verwandt, bei dem durch unterschiedliche logische Verknüpfungen des zu codierenden Binärzeichens und der m letzten Binärzeichen des dem zu codierenden Binärzeichen vorangegangenen Binärzeichens mehrere Daten- elemente der codierten Datenfolge erzeugt werden. Diese Codierung bietet den Vorteil, daß in Form der gezielt er-zeugten Redundanz der codierten Datenfolge es dem Kanaldecoder ermöglicht ist, bei einer zu decodierenden Datenfolge, bei der einzelne Datenelemente fehlerhaft empfangen wurden, die der codierten Datenfolge ursprünglich zugrundegelegene Binärzeichenfolge zurückzugewinnen.

Das Viterbi-Verfahren eignet sich also sowohl für die Entzerrung von Signalen, die einen dispersiven Übertragungskanal durchlaufen haben, als auch für die Decodierung von codierten Datenfolgen. Das Viterbi-Verfahren als solches ist beispielsweise in dem Aufsatz "The Viterbi Algorithm", G. David Forney jr., Proceedings of the IEEE, Vol. 61, No. 3, March 1973, Seiten 268 bis 278 beschrieben.

Für eine sogenannte Soft Decision Decodierung wird für die zu decodierenden Datenelemente einer codierten Datenfolge eine Zuverlässigkeitsinformation für die zu decodierende Datenfolge benötigt. Die Zuverlässigkeitsinformation ist eine Maßzahl, die angibt, mit welcher Wahrscheinlichkeit die zu decodierenden Datenelemente den gesendeten Datenelementen entsprechen.

Im oben genannten Aufsatz ist andeutungsweise erwähnt, wie eine Zuverlässigkeitsinformation bei der Viterbi-Entzerrung gewonnen werden kann. Die sich hierbei ergebende Zuverlässigkeitsinformation ist eine über mehrere aufeinanderfolgende Binärzeichen einer Binärzeichenfolge gemittelte Zuverlässigkeitsinformation. Die Zuverlässigkeitsinformation wird hierbei aus der besten und der zweitbesten bzw. aus einer beschränkten Anzahl der besten Lösungen gebildet. Diese Bildungsvorschrift erscheint nicht optimal.

Mit der EP-A 391 354 (Priorität: 3.4.1989, Veröffentlichungstag: 10.10.90) ist ein Verfahren zum Verallgemeinern des Viterbi-Algorithmus vorgeschlagen worden, bei dem in einer Metrikinkrementeinheit die Übergangskosten gebildet werden und in der nachfolgenden Addiervergleichauswähleinheit ein Addieren, ein Vergleichen sowie ein Auswählen vorgenommen wird. Außerdem werden für jeden Zustand die Differenzkosten von zwei eintreffenden Pfaden berechnet, wobei eine Zuverlässigkeitsinformation am Anfang jedes Pfades auf den höchsten Wert festgelegt wird.

Anschließend wird dann der Zuverlässigkeitswert des Pfades mit den kleinsten Kosten an die gemäß einer Tabelle an den Stellen aufgefrischt, wo die Informationsstellen von dem konkurrierenden Pfad abweichen. Durch das vorgeschlagene Verfahren wird ein Viterbi-Algorithmus geschaffen, an dessen Ausgang analoge Wertentscheidungen, d.h. Soft Decisions vorliegen.

Aufgabe der vorliegenden Erfindung ist es, ein Datenübertragungssystem bzw. eine Sende-/Empfangseinrichtung anzugeben, bei dem der Entzerrer für jeden geschätzten Binärwert eine Zuverlässigkeitsinformation in möglichst einfacher Weise liefert.

Diese Aufgabe wird durch ein digitales Übertragungssystem mit einem Entzerrer zum Bilden von binären Schätzwerten aus einer Folge von Abtastwerten eines Signales gelöst, die Binärwerten Null oder Eins von ausgegebenen Binärzeichen zuordenbar sind und bei der jeder Abtastwert von dem ihm zuordenbaren Binärzeichen und von n unmittelbar diesem Binärzeichen vorangegangenen Binärzeichen abhängig ist, indem jedem Abtastwert 2ⁿ Zustände zugeordnet werden und jeweils für den Übergang von einem Zustand auf einen zeitlich nachfolgenden Zustand eine Maßzahl für die Wahrscheinlichkeit des Überganges zugeordnet wird und durch Aneinanderreihung von Zustandsübergängen Pfade gebildet werden, wobei aus allen Maßzahlen eines Pfades eine Gesamtmaßzahl gebildet wird und von allen auf einen Zustand führenden Pfaden nur jeweils der mit der minimalsten Gesamtmaßzahl betrachtet wird, wobei der Entzerrer so ausgestaltet ist, daß von allen möglichen Pfaden, deren n-letzte Zustandsübergänge einem Binärwert Eins entsprachen und von allen möglichen Pfaden, deren n-letzte Zustandsübergänge einem Binärwert Null entsprachen, jeweils derjenige Pfad mit der kleinsten Maßzahl ausgewählt wird und daß der Binärwert, der dem kleinsten der beiden ausgewählten Werte zugeordnet ist, den Schätzwert ergibt und aus den beiden ausgewählten Maßzahlen eine Zuverlässigkeitsinformation P(b̂ᵢ₋ₙ) für diesen Schätzwert b̂ᵢ₋ₙ gebildet wird.

Dies hat den Vorteil, daß die Zuverlässigkeitsinformation tatsächlich für jedes einzelne geschätzte Binärzeichen gebildet wird. Außerdem wird die Zuverlässigkeitsinformation P(b̂ᵢ) aus den Wahrscheinlichkeitswerten gebildet, die jeweils dem günstigsten Fall für b̂ᵢ = 0 und für b̂ᵢ = 1 entspricht. Durch das Verhältnis dieser beiden Wahrscheinlichkeitswerte wird dann nämlich ausgedrückt, um wieviele Male ein Schätzwert wahrscheinlicher ist als der Komplementärwert zu diesem Schätzwert.

Eine weitere Aufgabe der vorliegenden Erfindung ist es. ein Übertragungssystem bzw. eine Sende-/Empfangseinrichtung mit einer großen Übertragungssicherheit anzugeben.

Die Aufgabe wird dadurch gelöst, daß zu übertragende Informationen xᵢ sendeseitig durch einen Faltungscoder in die Binärzeichen bᵢ umcodiert werden und empfangsseitig nach dem Entzerrer ein Faltungsdecoder angeordnet ist. welcher bei der Decodierung neben den entzerrten Schätzwerten auch die Binärzeichen b̂ᵢ und deren zugeordnete Zuverlässigkeitsinformaiton P(b̂ᵢ) verarbeitet.

Durch Einbeziehung der Zuverlässigkeitsinformation in die Decodierung kann auf diese Weise die Restfehlerrate der decodierten Binärzeichenfolge erheblich reduziert werden.

Anhand eines in der Zeichnung dargestellten Ausführungsbeispieles wird die Erfindung im folgenden näher beschrieben und erläutert.

Es zeigen:
- Fig. 1: eine schematische Schaltungsanordnung zur Gewinnung einer Zuverlässigkeitsinformation,
- Fig. 2: ein Kanalmodell eines dispersiven Übertragungskanals,
- Fig. 3: ein Zustandsdiagramm und
- Fig. 4: ein Zustandsdiagramm mit allen Pfaden für b̂ᵢ₋ₙ = 0.
- Fig. 5: ein Zustandsdiagramm mit allen Pfaden für b̂ᵢ₋ₙ = 1.
- Fig. 6: eine schematische Schaltungsanordnung eines digitalen Übertragungssystems mit geringer Restfehlerhäufigkeit.

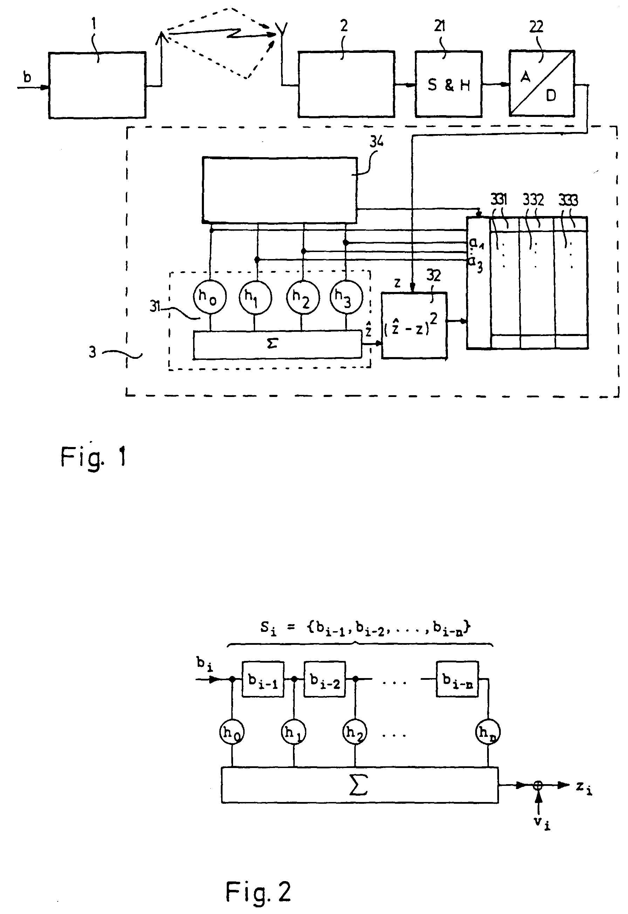

In Fig. 1 ist ein Funkübertragungssystem dargestellt, bei dem die zu übertragenden Informationen in Form von Binärzeichen bᵢ über einen Sender 1 abgestrahlt werden. Die in einem Empfänger 2 empfangenen Signale r(t) sind einem Entzerrer zugeführt. Auf der zwischen dem Sender 1 und dem Empfänger 2 liegenden Funkübertragungsstrecke wird das ausgesendete Signal s(t) durch Mehrwegeausbreitung infolge von Reflektionen und durch Überlagerung von Rauschen und sonstigen störenden Signalen verzerrt.

Auf diese Weise wird ein gesendetes Binärzeichen bᵢ durch verspätet eintreffende Signalanteile zuvor gesendeter Binärzeichen bᵢ₋₁, bᵢ₋₂, ... überlagert. Diese Überlagerung entspricht einer Signalverzerrung. Das zu einem gesendeten Binärzeichen empfangene Signal ist nicht mehr eindeutig einem niedrigen oder hohen Pegel zuordenbar. Der Einfluß bereits gesendeter Binärzeichen ist abhängig von der Laufzeitverzögerung der am Empfänger verzögert eintreffenden Signalanteile. Nach einer gewissen Zeit, die von der Charakteristik des Übertragungskanals abhängig ist, ist der Einfluß einer Signalbeeinflussung nicht mehr von Bedeutung und braucht daher bei der Entzerrung nicht mehr berücksichtigt zu werden. Vorteilhafterweise wird die Laufzeitverögerung als Anzahl n der in dieser Zeitspanne ausgesendeten Binärzeichen angegeben.

Da das empfangene Signal r(t) durch die Überlagerung einen analogen Signalverlauf aufweist, der ohne Entzerrung dem ursprünglich gesendeten Binärwert nicht zuordenbar ist, wird das empfangene Signal r(t) mittels eines Abtastgliedes 21 zu äquidistanten Zeitpunkten abgetastet. Die analogen Abtastwerte werden zur weiteren Verarbeitung mittels eines Analog-Digital-Umsetzers 22 in digitale Abtastwerte zᵢ umgesetzt und dem Entzerrer 3 zugeführt.

Der Entzerrung des empfangenen Signales r(t) liegt ein Kanalmodell zugrunde, das den dispersiven Übertragungskanal näherungsweise durch ein lineares endliches Transversalfilter beschreibt. In Fig. 2 ist ein solches Kanalmodell dargestellt, bei dem die Übertragungseigenschaften des Übertragungskanals durch Filterkoeffizienten h₀...hₙ nachgebildet werden. Bei der Übertragung des Binärzeichens bᵢ und dem diesen Binärzeichen bᵢ vorangegangenen n Binärzeichen bᵢ₋₁...bᵢ₋ₙ wird die Linear-Kombination bᵢ * h₀ + bᵢ₋₁ * hᵢ+ ...ᵢ₋ₙ * hₙ gebildet und zusätzlich mit einem Rauschsignal vᵢ überlagert.

Im Empfänger wird versucht, genau mit diesem Kanalmodell die auf dem Übertragungsweg auftretenden Verzerrungen durch die gedächtnisbehafteten Linear-Kombinationen mittels eines Transversalfilters 31 nachzubilden. Die Nachbildung des Übertragungsweges wird durch entsprechende Einstellung der Filterkoeffizienten h₀, h₁,...hₙ erreicht. Die Filterkoeffizienten h₀, h₁, ..., hₙ sind hierbei aus den Abtastwerten einer geschätzten Impulsantwort des Übertragungskanales ableitbar. Hierzu kann beispielsweise eine sogenannte Trainingssequenz verwendet werden, die aus einer Binärzeichenfolge besteht, die sowohl dem Sender als auch dem Empfänger bekannt ist. Bei jedem Empfang der Trainingssequenz werden die Filterkoeffizienten h₀, h₁,...hₙ so eingestellt, daß nach Durchlaufen des Transversalfilters die bekannte Binärzeichenfolge mit der geringsten Fehlerdifferenz erhalten wird. Die Schaltungsanordnung zur Bildung der Filterkoeffizienten ist im Ausführungsbeispiel nicht dargestellt.

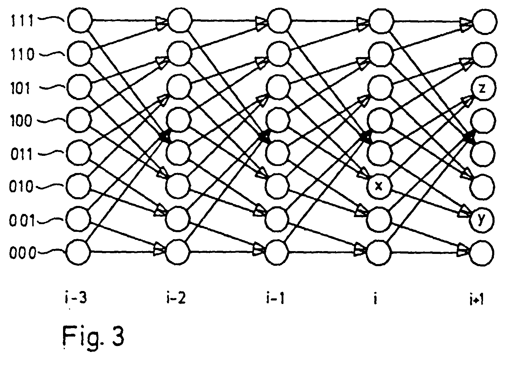

Zur Darstellung des im Empfänger angewandten Verfahrens wird im folgenden ein Zustandsdiagramm verwendet, mit dem üblicherweise auch das Viterbi-Verfahren beschrieben wird. Das in Fig. 3 dargestellte Zustandsdiagramm ist ein Graph mit in vertikaler Richtung aufgetragenen Reihen von jeweils 2ⁿ Knoten. Jeder Knoten repräsentiert eine der Kombinationen, die sich aus n Binärzeichen ergeben. n ist hierbei die Anzahl der einem gerade empfangenen Binärzeichen jeweils vorausgehenden Binärzeichen, deren Einfluß auf das zu schätzende Binärzeichen bei der Entzerrung berücksichtigt werden soll. Jede Kombination dieser Binärzeichen wird im folgenden als Zustand bezeichnet. Im Zustandsdiagramm sind in horizontaler Richtung mehrere dieser Reihen angeordnet. Jede vertikale Reihe ist einem bestimmten Abtastzeitpunkt i-3, i-2, i-1, i, i+1 zugeordnet. Die einzelnen, einem Knoten zuordenbaren, Binärwerte 000...111 werden als dessen Zustand bezeichnet. Ein Zustand entspricht jeweils einer möglichen Zuordnung der zu einem Zeitpunkt i empfangenen n-letzten digitalen Abtastwerte zu einer möglicherweise gesendeten Binärwertfolge.

Dem in horizontaler Richtung aufgereihten Knoten ist im Zustandsdiagramm jeweils der gleiche Zustand zugeordnet, wobei die diesen Zuständen zugeordnete Binärwertfolge links aufgetragen ist. Der erste, d.h. der am meisten links stehende, Binärwert eines Zustandes entspricht hierbei dem zuletzt empfangenen Abtastwert zugeordneten Binärwert, der nächst darauffolgende Binärwert der Zuordnung zu dem diesem Abtastwert vorangegangenen Abtastwert, usw.. Zum Zeitpunkt i entspricht also der erste Binärwert dem Schätzwert b̂ᵢ und der letzte Binärwert dem Schätzwert b̂ᵢ₋ₙ.

Beim Empfang eines neuen Abtastwertes zᵢ kann diesem sowohl der Binärwert 0 als auch der Binärwert 1 zugeordnet werden. Aus einer Binärwertfolge 010 wird durch die Zuordnung des neuesten Abtastwertes zu dem Binärwert 0 die Folge 0010 bzw. durch Zuordnung des neuesten Abtastwertes zu einer binären Eins die Folge 1010. Da durch den Empfang eines neuen Abtastwertes der jeweils älteste Abtastwert dieser Binärwertfolge ohne Einfluß auf die Entzerrung wird, wird dieser letzte Binärwert weggelassen. Aus dem Zustand 010 gelangt man auf diese Weise zu den Zuständen 001 bzw. 101. Von jedem Zustand gibt es durch die Zuordnung des Abtastwertes zu einem Binärwert 0 oder einem Binärwert 1 immer nur zwei Übergänge zu jeweils einem Zustand in der zu dieser Zustandsreihe jeweils benachbarten rechten Zustandsreihe.

Im Zustandsdiagramm der Fig. 3 sind alle auf diese Weise möglichen Übergänge durch Pfeile gekennzeichnet. So zeigen die zwei Pfeile vom Knoten x, dessen Zustand der Binärwertfolge 010 zum Zeitpunkt i zugeordnet ist, hierdurch zum einen für einen Null-Übergang auf den Knoten y, dem zum Zeitpunkt i+1 der Zustand 001 und zum anderen für einen Eins-Übergang auf den Knoten z, dem zum Zeitpunkt i+1 der Zustand 101, zugeordnet ist.

Für jeden Übergang von einem Knoten auf den nächstfolgenden späteren Knoten wird die Wahrscheinlichkeit berechnet, mit der dieser Übergang erfolgt ist. Durch Aneinanderreihung von zusammenhängenden Übergängen zwischen Knoten benachbarter vertikaler Knotenreihen erhält man einen Pfad. Dieser Pfad ist gleichbedeutend der rekonstruierten Binärfolge b̂ᵢ, b̂ᵢ₋₁...b̂ᵢ-n. Durch multiplikative Verknüpfung der Wahrscheinlichkeiten der einzelnen Übergänge eines Pfades ergibt sich die gesamte Wahrscheinlichkeit des Pfades.

Zur Berechnung der Übergangswahrscheinlichkeit von einem Zustand zu einem anderen Zustand werden die einzelnen Binärwerte der Binärzeichen bᵢ...bᵢ₋ₙ eines Zustands als Eingangsparameter c₁...cₙ des Transversalfilters verwendet. Der erste Eingangsparameter c₀ entspricht jeweils dem Binärwert des Übergangs, also dem gerade empfangenen Abtastwert zugeordneten Binärwert. Der Ausgangswert des Transversalfilters ergibt in erster Näherung unter Vernachlässigung von Störungen durch die im Eingangssignal enthaltenen Rauschsignale vᵢ etc. den Wert, den der Abtastwert annehmen müßte, wenn die als Eingangsparameter verwendete Binärzeichenfolge bᵢ, bᵢ₋₁...bᵢ₋ₙ über den Funkübertragungsweg gesendet und empfangen wird. Durch Vergleich des Ausgangswertes ẑᵢ mit dem tatsächlichen Abtastwert zᵢ kann daher die am wahrscheinlichsten gesendete Binärzeichenfolge gefunden werden.

Allerdings bietet eine große Übergangswahrscheinlichkeit von einem Zustand zu einem zeitlich folgenden Zustand noch keine ausreichende Gewähr für die Richtigkeit dieses Übergangs. Denn durch kurzzeitige Störungen oder Signalrauschen kann zufälligerweise ein tatsächlich nicht erfolgter Zustandsübergang als wahrscheinlichster Übergang erscheinen. Korrektere Schätzungen der Zustandsübergänge und somit der Schätzung des Binärwertes des gerade empfangenen digitalen Abtastwertes werden durch eine Berücksichtigung des gesamten bisherigen Signalverlaufs in Form einer Wahrscheinlichkeitsbetrachtung aller Zustandsübergänge, die zu einem der 2ⁿ Zustände des betrachteten Zeitpunktes führen, erzielt. Hierzu kann jedem Zustand eine Gesamtmaßzahl zugeordnet werden, die entsprechend einer Bildung der Verbundwahrscheinlichkeit durch multiplikative Verknüpfung aller einzelnen Maßzahlen der einzelnen Zustandsübergänge, die auf diesen Zustand führten, gebildet wird.

Es ist bekannt, anstelle der Maßzahlen sogenannte Metriken zu verwenden. Die Metrik berechnet sich hierbei aus dem negativen Logarithmus der jeweiligen Maßzahl. Dies hat unter anderem den Vorteil, daß zur Errechnung einer Verbundwahrscheinlichkeit, bei der die einzelnen Maßzahlen zu multiplizieren sind, nun die Metriken nur noch addiert werden müssen. Im Ausführungsbeispiel wird zur Bildung der Metrik der Ausgangswert ẑᵢ des Transversalfilters 31 vom digitalen Abtastwert zᵢ in einem Signalbewerter 32 subtrahiert und betragsmäßig quadriert. Auf diese Weise wird eine quadratische Distanz gebildet. Je kleiner die quadratische Distanz ist, umso größer ist die Wahrscheinlichkeit, daß der empfangene Abtastwert aus der als Eingangsparameter verwendeten Binärzeichenfolge hervorgegangen ist.

Wegen der Linear-Kombinationen der jeweils n letzten Binärzeichen kann aber immer erst nach Empfang aller n Binärzeichen ein optimaler Schätzwert gebildet werden. Beim Empfang des Abtastwertes zᵢ wird daher der Schätzwert b̂ᵢ₋ₙ gebildet.

Der dem Abtastwert zᵢ zugeordnete Schätzwert b̂ᵢ ist zeitlich den Übergängen von den Zuständen des Zeitpunkts i auf die Zustände des Zeitpunkts i+1 zugeordnet.

Zur Bildung des Schätzwertes b̂ᵢ₋ₙ werden daher in einem ersten Schritt zunächst alle Übergangswahrscheinlichkeiten von allen Zuständen i auf die zeitlich folgenden Zustände i+1 berechnet, bei denen der Übergang des Binärwertes b̂ᵢ₋ₙ dem Binärwert 0 zugeordnet war. Die Gesamtmetrik der neuen auf diese Weise erreichbaren Zustände wird vorläufig dann aus der Gesamtmetrik des betreffenden Vorgängerzustandes L des Zeitpunkts i und der Metrik des Übergangs von diesem Vorgängerzustand auf den nächsten Zustand des Zeitpunkts i+1 berechnet.

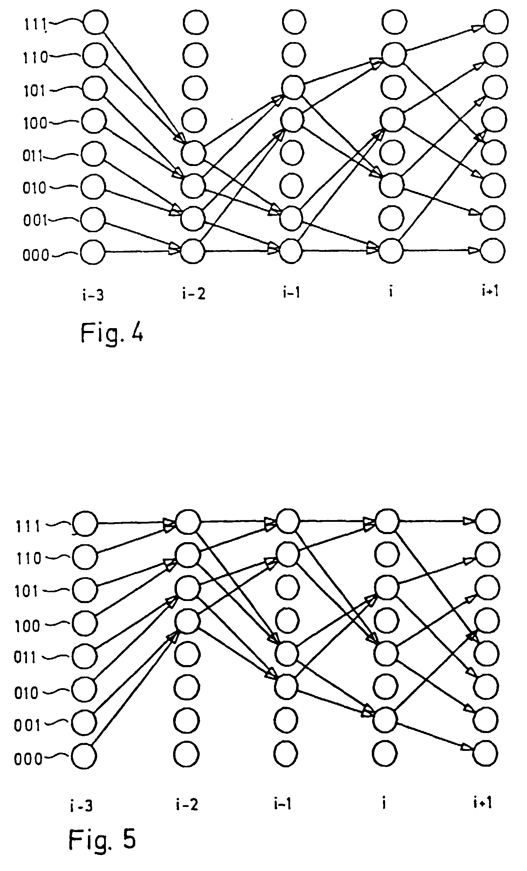

In einem zweiten Schritt wird auf gleiche Weise jeweils die Gesamtmetrik der Zustände zum Zeitpunkt i+1 berechnet, bei denen die Binärzeichen b̂ᵢ₋ₙ einem Binärwert 1 entsprachen, also einen Eins-Übergang vollzogen. In Fig. 4 ist das Zustandsdiagramm der Fig. 3 wiedergegeben, bei dem jetzt nur noch alle Pfade eingezeichnet sind, bei denen alle Übergänge vom Zeitpunkt i-n = i-3 auf den Zeitpunkt i+1-n = i-2 Null-Übergänge, d.h. alle Übergänge, bei denen Binärzeichen b̂ᵢ₋₃ jeweils der Binärwert 0 zugeordnet war. Fig. 5 hingegen ist ein Zustandsdiagramm, in dem nur noch die Pfade eingezeichnet sind, bei denen den Übergängen vom Zeitpunkt i-3 auf den Zeitpunkt i-2 für das Binärzeichen b̂ᵢ₋₃ der Binärwert 1 zugeordnet war.

Aus allen Gesamtmetriken der Zustände, die sich durch einen Nullübergang und aus allen Gesamtmetriken der Zustände, die sich aus einem Einsübergang ergeben haben, wird jeweils die kleinste Gesamtmetrik ermittelt. Das heißt, es wird aus dem Teilzustandsdiagramm der Fig. 4 und dem Teilzustandsdiagramm der Fig. 5 jeweils der Pfad mit der kleinsten Gesamtmetrik ausgewählt. Diese beiden Pfade werden im folgenden als Null-Minimalpfad bzw. als Eins-Minimalpfad bzw. die diesen Pfaden zugeordneten Gesamtmetriken als Null-Minimal-Gesamtmetrik und als Eins-Minimal-Gesamtmetrik bezeichnet.

Der vom Zeitpunkt i-n ausgehende Übergang, der der kleineren dieser beiden ausgewählten Minimal-Gesamtmetriken zugeordnet ist, ergibt dann den Schätzwert b̂ᵢ₋ₙ für das zum Zeitpunkt i-n gesendete Binärzeichen bᵢ₋ₙ.

Jede der beiden ausgewählten Minimal-Gesamtmetriken gibt für sich die Wahrscheinlichkeit wieder, mit der der jeweils ausgewählte Pfad, der durch den Zustand des jeweils ausgewählten Knotens repräsentiert ist, im jeweils günstigsten Fall dem Schätzwert b̂ᵢ₋ₙ = 0 bzw. dem Schätzwert b̂ᵢ₋ₙ = 1 zugeordnet werden kann. Diese Wahrscheinlichkeitswerte lassen sich aus den Gesamtmetriken zurückberechnen. Bei Maßzahlen müßten die einzelnen Maßzahlen dividiert werden, um eine Zuverlässigkeitsinformation zu erhalten, die angibt, um wieviele Mal der gewählte Schätzwert wahrscheinlicher ist als sein Komplementärwert.

Durch Verwendung der Metriken vereinfacht sich diese Berechnung. Durch Subtraktion der Null-Minimal-Gesamtmetrik von der Eins-Minimal-Gesamtmetrik wird ein Zahlenwert erhalten, dessen Vorzeichen den wahrscheinlicheren der beiden Schätzwerte angibt. Ein positives Vorzeichen zeigt hierbei an, daß der Binärwert 1 als Schätzwert wahrscheinlicher ist als der Binärwert 0. Der Absolutbetrag dieses Wertes hingegen bildet die eigentliche Zuverlässigkeitsinformation P(b̂ᵢ₋ₙ).

In einem letzten Schritt werden die beiden für einen Zustand vorliegenden neu gebildeten Gesamtmaßzahlen für jeden Zustand miteinander verglichen und der jeweils kleinere der beiden Werte als neue Gesamtmaßzahl dem Zustand zugeordnet.

Zur Durchführung dieses Verfahrens sind im Ausführungsbeispiel eine Reihe von 2ⁿ Speicherplätzen in einem Speicherbaustein 33 vorgesehen. Die Adresse eines aₙ...a₁ Speicherplatzes entspricht hierbei jeweils einem der 2ⁿ Zustände. Unter der Adresse eines Speicherplatzes ist in ersten Registerzellen 331 die einem Zustand zugeordnete Gesamtmetrik gespeichert. Eine Steuerschaltung 34 gibt bei der Ansteuerung eines Speicherplatzes dessen Adresse aₙ...a₁ gleichzeitig als Eingangsparameter cᵢ...cₙ dem Transversalfilter 31 vor.

Der erste Eingangsparameter c₀ wird von der Steuerschaltung für jede gebildete Adresse einmal als Binärwert 0 vorgegeben. Aus dem auf diese Weise erhaltenen Wert ẑᵢ des Transversalfilters 31 und dem Abtastwert zᵢ wird in der Bewertungsschaltung die quadratische Distanz 1 = (ẑᵢ-zᵢ)². Aus dieser quadratischen Distanz 1 und der in ersten Registerzellen 331 unter der jeweiligen Adresse gespeicherten Gesamtmetrik L wird eine neue Gesamtmetrik L₀ gebildet, welche in zweiten Registerzellen 332 unter der jeweils eingestellten Adresse gespeichert wird. Auf gleiche Weise wird dem ersten Eingangsparameter c₀ der Binärwert 1 vorgegeben und die auf diese Weise erhaltene Gesamtmetrik L₁ in dritten Registerzellen 333 gespeichert.

Nachdem die Steuerschaltung 34 durch Durchlaufen aller Adresskombinationen alle zweiten und dritten Registerinhalte neu berechnet hat, wird aus allen neuen Gesamtmetriken L₀ der zweiten Registerzellen 332 und aus allen Gesamtmetriken L₁ der dritten Registerzellen 333 jeweils der kleinste Wert ausgewählt. Diese beiden Werte werden subtrahiert. Wie bereits geschildert, ergibt sich aus dem Vorzeichen der Differenz der Schätzwert b̂ᵢ₋ₙ und aus dem Absolutbetrag der Differenz die gewünschte Zuverlässigkeitsinformation P(b̂ᵢ₋ₙ).

Nachdem der Schätzwert ermittelt ist, erfolgt nun die Umspeicherung der in den zweiten und dritten Registern 332, 333 abgelegten Gesamtmetriken für die neuen Zustände. Hierzu erzeugt die Steuerschaltung zunächst die Adressen 000 und 001. Aus den Zuständen 000 und 001 ergibt sich, wie bereits beschrieben, durch einen Null-Übergang jeweils der Zustand 000. Die Inhalte der zweiten Registerzellen 332 der Adressen 000 und 001 entsprechen genau einem Null-Übergang von diesen beiden Zuständen auf den Zustand 000. Der Inhalt dieser beiden angesteuerten zweiten Registerzellen 332 wird daher miteinander verglichen und der kleinere der beiden Werte wird als neuer Inhalt der ersten Registerzellen 331 unter der Adresse 000 eingeschrieben. Die Inhalte der dritten Registerzellen 333 unter den Adressen 000 und 001 entsprechen einem Eins-Übergang auf den Zustand 100. Der Inhalt dieser beiden dritten Registerzellen wird daher ebenfalls verglichen und der kleinere der beiden in diesen Registerzellen gespeicherten Gesamtmetriken als neue Gesamtmetrik unter der Adresse 100 in der ersten Registerzelle 331 abgelegt.

Durch entsprechende Ansteuerung der übrigen Registerzellen und dem Vergleich benachbarter Registerzellen wird jeweils die neue Gesamtmetrik eines neuen Zustands ermittelt und in die dem neuen Zustand zugeordnete Adresse der ersten Registerzellen eingeschrieben. Auf diese Weise werden in alle ersten Registerzellen die neuen Gesamtmetriken eingeschrieben. Anschließend wird bis zum Eingang eines neuen Abtastwertes zᵢ₊₁ gewartet, und auf schon beschriebene Weise der zugehörige Schätzwert b̂ᵢ₊₁₋ₙ gebildet.

In einer verbesserten Ausführungsform der Erfindung wird die Zuverlässigkeitsinformation P(b̂ᵢ₋ₙ) mit der zum Zeitpunkt des Empfangs des Signals geschätzten Rauschleistung v̂ bewertet. Dieser Bewertung liegt die Erkenntnis zugrunde, daß höhere Rauschleistungen für die Schätzung größere Unsicherheiten bedeuten. Die Bewertung der Zuverlässigkeitsfunktion kann derart vorgenommen werden, daß die Zuverlässigkeitsinformtion durch den Betrag der geschätzten Rauschleistung v̂ dividiert wird. Die Schätzung der Rauschleistung wird hierbei mittels bekannter Methoden durchgeführt.

Besonders vorteilhaft ist eine Verarbeitung der durch die Rauschleistung bewerteten Zuverlässigkeitsinformationen für Übertragungssysteme, bei denen durch sogenanntes Interleaving zeitlich aufeinanderfolgende Datenelemente so ineinander verschachtelt werden, daß benachbarte Datenelemente zeitlich versetzt übertragen werden. Da auch die Rauschleistung eine zeitabhängige Funktion ist, werden ursprünglich zeitlich benachbarte Datenelemente durch die unterschiedlichen Zeitpunkte der Übertragung unterschiedlich stark durch die Rauschleistung gestört. Bei der Entschachtelung der Signale kann dann auf diese Weise bevorzugt auf die weniger stark gestörten Datenelemente zurückgegriffen werden. Mit der bewerteten Zuverlässigkeitsinformation hat man so die Möglichkeit, bei der Weiterverarbeitung der Datenelemente bevorzugt diejenigen Datenelemente zur Bearbeitung heranzuziehen, die ein Optimum an Sicherheit gegen fehlerhafte Schätzung bilden.

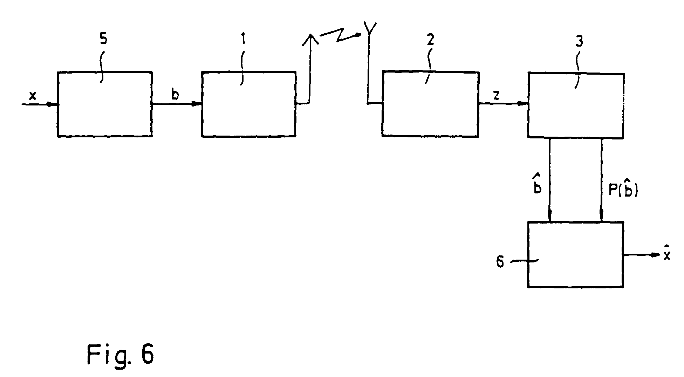

In Fig. 6 ist als weiteres Ausführungsbeispiel der Erfindung ein digitales Übertragungssystem dargestellt, bei dem zu übertragende Informationen xₖ, xₖ₊₁... zunächst einem Faltungscoder 5 zugeführt sind. Der Faltungscoder 5 setzt die Eingangsfolge xₖ, xₖ₊₁,... in eine redundante Datenfolge mit den Binärzeichen bᵢ, bᵢ₋₁, ... um, welche dann wie bereits beschrieben über einen dispersiven Übertragungskanal übertragen werden. Am Empfänger 2 wird das in Form von Abtastwerten zᵢ, zᵢ₊₁,... empfangene Signal in der bereits beschriebenen Weise durch den Entzerrer 3 entzerrt. Die bei der Entzerrung entstehenden Schätzwer te b̂ᵢ b̂ᵢ₊₁,....... und die zugehörigen Zuverlässigkeitsinformationen P̂(bᵢ), P̂(bᵢ₋₁),... sind einem Decodierer 6 zugeführt. Im Decoder 6 wird die Schätzwertfolge b̂ᵢ, b̂ᵢ₊₁,.. zu einer Folge x̂ₖ, x̂ₖ₊₁,... decodiert. Im Ausführungsbeispiel wird zur Decodierung ein Viterbi-Decoder verwendet.

Bei der bekannten Viterbi-Decodierung wird die empfangene codierte Signalfolge jeweils mit allen gültigen Codefolgen, die der Coder 5 erzeugt haben könnte, verglichen. Es ist bekannt, als Metrik für den Viterbi-Decoder die Anzahl der Bits, in denen die entzerrte Datenfolge sich von den einzelnen Codeelementen des Codevorrats unterscheidet, zu verwenden. Durch Multiplizieren einer auf diese Weise erhaltenen Metrik oder einer auf andere Weise erhaltenen Metrik mit der Zuverlässigkeitsinformation P(b̂ᵢ) erhält man eine Bewertung einer zu decodierenden Datenfolge. Auf diese Weise erhöht sich die Wahrscheinlichkeit, daß bei der Decodierung auch tatsächlich die gesendete Datenfolge zurückerhalten wird, weil der Decoder nunmehr nicht nur die Signalredundanz zur Decodierung verwendet, sondern nun auch Informationen erhält, welchen einzelnen Binärzeichen der zu decodierenden Datenfolge er mehr und welchen er weniger vertrauen darf.

## Patentansprüche

1. Digitales Übertragungssystem mit einem Entzerrer zum Bilden von binären Schätzwerten (b̂ₖ, b̂ₖ₋₁, b̂ₖ₋₂, ...) aus einer Folge von Abtastwerten (zₖ, zₖ₋₁, zₖ₋₂, ...) eines Signales z(t), die Binärwerten Null oder Eins von ausgegebenen Binärzeichen (bᵢ) zuordenbar sind und bei der jeder Abtastwert (zᵢ) von dem ihm zuordenbaren Binärzeichen (bᵢ) und von n unmittelbar diesem Binärzeichen vorangegangenen Binärzeichen (bᵢ₋₁, bᵢ₋₂, ..., bᵢ₋ₙ) abhängig ist, indem jedem Abtastwert (zᵢ) 2ⁿ Zustände zugeordnet werden und jeweils für den Übergang von einem Zustand auf einen zeitlich nachfolgenden Zustand eine Maßzahl (1) für die Wahrscheinlichkeit des Überganges zugeordnet wird und durch Aneinanderreihung von Zustandsübergängen Pfade gebildet werden, wobei aus allen Maßzahlen (1) eines Pfades eine Gesamtmaßzahl (L) gebildet wird und von allen auf einen Zustand führenden Pfaden nur jeweils der mit der minimalsten Gesamtmaßzahl betrachtet wird, wobei der Entzerrer so ausgestaltet ist, daß von allen möglichen Pfaden, deren n-letzte Zustandsübergänge einem Binärwert Eins entsprachen und von allen möglichen Pfaden, deren n-letzte Zustandsübergänge einem Binärwert Null entsprachen, jeweils derjenige Pfad mit der kleinsten Maßzahl ausgewählt wird und daß der Binärwert, der dem kleinsten der beiden ausgewählten Werte zugeordnet ist, den Schätzwert (b̂ᵢ₋ₙ) ergibt und aus den beiden ausgewählten Maßzahlen eine Zuverlässigkeitsinformation (P(b̂ᵢ₋ₙ)) für diesen Schätzwert (b̂ᵢ₋ₙ) gebildet wird.

2. Digitales Übertragungssystem nach Anspruch 1,
dadurch gekennzeichnet,
daß die Zuverlässigkeitsinformation (P(b̂ᵢ)) durch das Verhältnis der den beiden ausgewählten Pfaden entsprechenden Wahrscheinlichkeitswerte gebildet wird.

3. Digitales Übertragungssystem nach Anspruch 2,
dadurch gekennzeichnet,
daß als Maßzahl (1) die quadratische Distanz der Wahrscheinlichkeit des Überganges zwischen zwei Zuständen verwendet wird und zur Bildung der Gesamtmaßzahl (L₀, L₁) die ermittelte Maßzahl für einen Zustandsübergang zur bisherig ermittelten Gesamtmaßzahl (L) addiert wird.

4. Digitales Übertragungssystem nach Anspruch 3,
dadurch gekennzeichnet,
daß die Gesamtmaßzahl (L₀) des dem Binärwert Null entsprechenden n-letzten Zustandsübergangs von der Gesamtmaßzahl des dem Binärwert Eins entsprechenden n-letzten Zustandsübergangs subtrahiert wird und daß das Vorzeichen der Differenz den Schätzwert (b̂ᵢ₋ₙ) und der Absolutbetrag der Differenz die dem Schätzwert (b̂ᵢ₋ₙ) zugeordnete Zuverlässigkeitsinformation (P(b̂ᵢ₋ₙ)) ergibt.

5. Digitales Übertragungssystem nach einem der Ansprüche 1, 2, 3 oder 4,
dadurch gekennzeichnet,
daß die Zuverlässigkeitsinformation (P(b̂ᵢ₋ₙ)) mit einer von einer ermittelten Rauschleistung (v̂ᵢ₋ₙ) abhängigen Größe berichtigt wird.

6. Digitales Übertragungssystem nach einem der Ansprüche 1, 2, 3, 4 oder 5,
dadurch gekennzeichnet,
daß zu übertragende Informationen (xᵢ) sendeseitig durch einen Faltungscoder in die Binärzeichen (bᵢ) umcodiert werden und empfangsseitig nach dem Entzerrer ein Faltungsdecoder angeordnet ist, welcher bei der Decodierung neben den entzerrten Schätzwerten auch die Binärzeichen (b̂ᵢ) und deren zugeordnete Zuverlässigkeitsinformation (P(b̂ᵢ)) verarbeitet.

7. Digitales Übertragungssystem nach Anspruch 6,
dadurch gekennzeichnet,
daß der Faltungsdecoder nach dem Viterbi-Verfahren arbeitet und die Zuverlässigkeitsinformation (P(b̂ᵢ)) als Metrik heranzieht.

8. Digitales Übertragungssystem nach einem der Ansprüche 1 bis 7,
dadurch gekennzeichnet,
daß das digitale Funkübertragungssystem ein Mobilfunkübertragungssystem ist.

9. Sende-/Empfangsstation für ein digitales Mobilfunkübertragungssystem mit einem Entzerrer zum Bilden von binären Schätzwerten (b̂ₖ, b̂_{k-1,} b̂ₖ₋₂, ...) aus einer Folge von Abtastwerten (zₖ, zₖ₋₁, zₖ₋₂, ...) eines Signales z(t), die Binärwerten Null oder Eins von ausgegebenen Binärzeichen (bᵢ) zuordenbar sind und bei der jeder Abtastwert (zᵢ) von dem ihm zuordenbaren Binärzeichen (bᵢ) und von n unmittelbar diesem Binärzeichen vorangegangenen Binärzeichen (bᵢ₋₁, bᵢ₋₂, ..., bᵢ₋ₙ) abhängig ist, indem jedem Abtastwert (zᵢ) 2ⁿ Zustände zugeordnet werden und jeweils für den Übergang von einem Zustand auf einen zeitlich nachfolgenden Zustand eine Maßzahl (1) für die Wahrscheinlichkeit des Überganges zugeordnet wird und durch Aneinanderreihung von Zustandsübergängen Pfade gebildet werden, wobei aus allen Maßzahlen (1) eines Pfades eine Gesamtmaßzahl (L) gebildet wird und von allen auf einen Zustand führenden Pfaden nur jeweils der mit der minimalsten Gesamtmaßzahl betrachtet wird, wobei der Entzerrer so ausgestaltet ist, daß von allen möglichen Pfaden, deren n-letzte Zustandsübergänge einem Binärwert Eins entsprachen und von allen möglichen Pfaden, deren n-letzte Zustandsübergänge einem Binärwert Null entsprachen, jeweils derjenige Pfad mit der kleinsten Maßzahl ausgewählt wird und daß der Binärwert, der dem kleinsten der beiden ausgewählten Werte zugeordnet ist, den Schätzwert (b̂ᵢ₋ₙ) ergibt und aus den beiden ausgewählten Maßzahlen eine Zuverlässigkeitsinformation (P(b̂ᵢ₋ₙ)) für diesen Schätzwert (b̂ᵢ₋ₙ) gebildet wird.

10. Sende-/Empfangsstation nach Anspruch 9,
dadurch gekennzeichnet,
daß zu übertragende Informationen (xᵢ) sendeseitig durch einen Faltungscoder in die Binärzeichen (bᵢ) umcodiert werden und empfangsseitig nach dem Entzerrer ein Faltungsdecoder angeordnet ist, welcher bei der Decodierung neben den entzerrten Schätzwerten auch die Binärzeichen (b̂ᵢ) und deren zugeordnete Zuverlässigkeitsinformation (P(b̂ᵢ)) verarbeitet.

## Revendications

1. Système de transmission numérique avec un redresseur pour la formation de valeurs d'estimation binaires (b̂ₖ, b̂ₖ₋₁, b̂ₖ₋₂,...) à partir d'une séquence de valeurs de balayage (zₖ, zₖ₋₁, zₖ₋₂,...) d'un signal z(t), qui peuvent être affectées aux valeurs binaires zéro ou un de signes binaires émis (bᵢ), chaque valeur de balayage (zᵢ) dépendant du signe binaire qui peut lui être affecté, (bᵢ) et de n signes binaires (bᵢ₋₁, bᵢ₋₂,..., bᵢ₋ₙ) précédant directement ce signe binaire puisqu'à chaque valeur de balayage (zᵢ) sont affectés 2ⁿ états et une mesure (1) pour la probabilité de la transition est respectivement affectée pour la transition d'un état à un état temporellement en aval et, par la succession de transitions d'état, sont formées des voies, une mesure globale (L) étant formée à partir de toutes les mesures (1) d'une voie et parmi toutes les voies conduisant à un état, seule la voie avec la mesure globale minimale est prise en considération, le redresseur étant conçu de telle manière que, de toutes les voies possibles dont les n dernières transitions d'état correspondaient à une valeur binaire un et de toutes les voies possibles dont les n dernières transitions d'état correspondaient à une valeur binaire zéro est respectivement sélectionnée la voie avec la mesure la plus petite et que la valeur binaire qui est affectée à la plus petite des deux valeurs sélectionnées donne la valeur d'estimation (b̂ᵢ₋ₙ) et une information de fiabilité (P(b̂ᵢ₋ₙ)) est formée pour cette valeur d'estimation (b̂ᵢ₋ₙ) à partir des deux mesures sélectionnées.

2. Système de transmission numérique selon la revendication 1,
caractérisé en ce
que l'information de fiabilité (P(b̂ᵢ)) est formée par le rapport des valeurs de probabilité correspondant aux deux voies sélectionnées.

3. Système de transmission numérique selon la revendication 2,
caractérisé en ce
que la distance carrée de la probabilité de la transition entre deux états est utilisée comme mesure (1) et la mesure déterminée pour une transition d'état est additionnée à la mesure globale (L) déterminée jusqu'à présent pour la formation de la mesure globale (L₀, L₁).

4. Système de transmission numérique selon la revendication 3,
caractérisé en ce
que la mesure globale (L₀) des n dernières transitions d'état correspondant à la valeur binaire zéro est soustraite de la mesure globale des n dernières transitions d'état correspondant à la valeur binaire un et que le signe de la différence donne la valeur d'estimation (b̂ᵢ₋ₙ) et la valeur absolue de la différence l'information de fiabilité (P(b̂ᵢ₋ₙ)) affectée à la valeur d'estimation (b̂ᵢ₋ₙ).

5. Système de transmission numérique selon l'une des revendications 1, 2, 3 ou 4,
caractérisé en ce
que l'information de fiabilité (P(b̂ᵢ₋ₙ)) est rectifiée avec une grandeur dépendant de la puissance de bruit déterminée (v̂ᵢ₋ₙ).

6. Système de transmission numérique selon l'une des revendications 1, 2, 3, 4 ou 5,
caractérisé en ce
que les informations à transmettre (xᵢ) sont codées côté émetteur par un codeur de convolution en signes binaires (bᵢ) et un décodeur de convolution est disposé côté récepteur après le redresseur, et traite lors du décodage, outre les valeurs d'estimation redressées, les signes binaires (b̂ᵢ) et l'information de fiabilité (P(b̂ᵢ)) qui leur est affectée.

7. Système de transmission numérique selon la revendication 6,
caractérisé en ce
que le décodeur de convolution travaille selon le procédé de Viterbi et utilise l'information de fiabilité (P(b̂ᵢ)) comme métrique.

8. Système de transmission numérique selon l'une des revendications 1 à 7,
caractérisé en ce
que le système numérique de transmission radio est un système de radiotéléphone mobile.

9. Station émetteur/récepteur pour un système numérique de radiotéléphone mobile avec un redresseur pour la formation de valeurs d'estimation binaires (b̂ₖ, b̂ₖ₋₁,b̂ₖ₋₂,...) à partir d'une séquence de valeurs de balayage (zₖ, zₖ₋₁,zₖ₋₂,...) d'un signal z(t), qui peuvent être affectées aux valeurs binaires zéro ou un des signes binaires (bᵢ) émis, chaque valeur de balayage (zᵢ) dépendant du signe binaire (bᵢ) qui peut lui être affecté et de n signes binaires (bᵢ₋₁, bᵢ₋₂, ..., bᵢ₋ₙ) précédant immédiatement ce signe binaire, puisque 2ⁿ états sont affectés à chaque valeur de balayage (zᵢ) et une mesure (1) pour la probabilité de la transition est affectée pour la transition d'un état à un état temporellement en aval et, par la succession de transitions d'état, des voies sont formées, une mesure globale (L) étant formée à partir de toutes les mesures (1) d'une voie et, de toutes les voies conduisant à un état, seule celle avec la mesure globale respectivement minimale est prise en considération, le redresseur étant conçu de telle manière que, parmi toutes les voies possibles dont les n dernières transitions d'état correspondaient à une valeur binaire un et de toutes les voies possibles dont les n dernières transitions d'état correspondaient à une valeur binaire zéro, c'est respectivement la voie avec la mesure minimale qui est sélectionnée et que la valeur binaire qui est affectée à la plus petite des deux valeurs sélectionnées donne la valeur d'estimation (b̂ᵢ₋ₙ) et une information de fiabilité (P(b̂ᵢ₋ₙ) pour cette valeur d'estimation (b̂ᵢ₋ₙ) est formée à partir des deux mesures sélectionnées.

10. Station émettrice/réceptrice selon la revendication 9,
caractérisé en ce
que les informations à transmettre (xᵢ) sont codées côté émetteur par un codeur de convolution en signes binaires (bᵢ) et qu'un décodeur de convolution est disposé côté récepteur après le redresseur et traite lors du décodage, outre les valeurs d'estimation redressées, les signes binaires (b̂ᵢ) et l'information de fiabilité (P(b̂ᵢ) qui leur est affectée.

## Claims

1. A digital transmission system comprising an equalizer for forming binary estimates (b̂ₖ, b̂ₖ₋₁, b̂ₖ₋₂, ...) from a sequence of sample values (zₖ, zₖ₋₁,zₖ₋₂, ...) of a signal z(t), to which estimates can be assigned binary "zero" or "one" values of issued bits (binary digits) (bᵢ) and with which each sample value (zᵢ) depends on the bit (bᵢ) that can be assigned thereto and on n bits (bᵢ₋₁, bᵢ₋₂, ..., bᵢ₋ₙ₎ immediately preceding this bit, in that 2ⁿ states are assigned to each sample value (zᵢ) and a probability function (1) is assigned to the probability of the transition from one state to a following state and paths are formed by stringing together state transitions, an overall probability function (L) being formed from all the probability functions (I) of a path, while from all the paths leading to a state only the path that has the minimum overall probability function is considered, the equalizer being arranged such that from all possible paths whose n last state transitions corresponded to a binary "one" value and from all possible paths whose n last state transitions corresponded to a binary "zero" value the path that has the smaller probability value is selected, and in that the binary value assigned to the smaller of the two selected probability values provides the estimate (b̂ᵢ₋ₙ) and a reliability information signal (P(b̂ᵢ₋ₙ)) for this estimate (b̂ᵢ₋ₙ) is formed from the two selected probability functions.

2. A digital transmission system as claimed in Claim 1, characterized in that the reliability information (P(b̂ᵢ))
is formed by the ratio between the probability values corresponding to the two selected paths.

3. A digital transmission system as claimed in Claim 2, characterized in that as a probability function (I) is used the quadratic distance of the probability of transition between two states and for the formation of the overall probability function (L₀, L₁) the formed probability function for a state transition is added up to the overall probability function (L) determined thus far.

4. A digital transmission system as claimed in Claim 3, characterized in that the overall probability function (L₀) of the n last state transition corresponding to the binary "zero" value is subtracted from the overall number of the n last state transition corresponding to the binary "one" value and in that the sign of the difference produces the estimate (b̂ᵢ₋ₙ) and the absolute value of the difference forms the reliability information (P(b̂ᵢ₋ₙ)) assigned to the estimate (b̂ᵢ₋ₙ).

5. A digital transmission system as claimed in one of the Claims 1, 2, 3 or 4, characterized in that the reliability information (P(b̂ᵢ₋ₙ₎) is corrected by a magnitude depending on an average noise power (v̂ᵢ₋ₙ).

6. A digital transmission system as claimed in one of the Claims 1, 2, 3, 4 or 5, characterized in that information to be transmitted (xᵢ) is encoded into bits (bᵢ) at the transmitting end by a convolution encoder and in that at the receiving end after the equalizer a convolution decoder is inserted which processes the bits (b̂ᵢ) and the reliability information (P(b̂ᵢ)) assigned thereto, in addition to equalized estimates.

7. A digital transmission system as claimed in Claim 6, characterized in that the convolution decoder operates according to the Viterbi method and regards the reliability information (P(b̂ᵢ)) as a metric.

8. A digital transmission system as claimed in Claims 1 to 7, characterized in that the digital transmission system is a mobile radio transmission system.

9. A transceiver station for a digital mobile radio transmission system comprising an equalizer for forming binary estimates (b̂ₖ, b̂ₖ₋₁, b̂ₖ₋₂, ...) from a sequence of sample values (zₖ, zₖ₋₁,zₖ₋₂, ...) of a signal z(t), to which estimates can be assigned binary "zero" or "one" values of issued bits (binary digits) (bᵢ) and with which each sample value (zᵢ) depends on the bit (bᵢ) that can be assigned thereto and on n bits (bᵢ₋₁, bᵢ₋₂, ..., bᵢ₋ₙ) immediately preceding this bit, in that 2ⁿ states are assigned to each sample value (zᵢ) and a probability function (1) is assigned to the probability of the transition from one state to a following state and paths are formed by stringing together state transitions, an overall probability function (L) being formed from all the probability functions (1) of a path, while from all the paths leading to a state only the path that has the minimum overall probability function is considered, the equalizer being arranged such that from all possible paths whose n last state transitions corresponded to a binary "one" value and from all possible paths whose n last state transitions corresponded to a binary "zero" value the path that has the smaller probability value is selected, and in that the binary value assigned to the smaller of the two selected probability values provides the estimate (b̂ᵢ₋ₙ) and a reliability information signal (P(b̂ᵢ₋ₙ)) for this estimate (b̂ᵢ₋ₙ) is formed from the two selected probability functions.

10. A transceiver station as claimed in claim 9, characterized in that information signals xᵢ to be transmitted are encoded by a convolution encoder into the bits bᵢ at the transmitting end, and, at the receiving end, after the equalizer, a convolutional decoder is inserted processing the bits b̂ᵢ and the reliability information P(b̂ᵢ) assigned thereto in addition to equalized estimates.
